# EUROPÄISCHE PATENTANMELDUNG

(11) **EP 0 666 524 A2**
(43) Veröffentlichungstag der Anmeldung: **09.08.1995**
(21) Anmeldenummer: 95101195.6
(22) Anmeldetag: 28.01.1995
(51) Int. Cl.: G06F 1/18

(54) **Personal-Computer mit einem Gehäuse, einer Hauptplatine, Steckkarten und einer Haltevorrichtung hierfür**

(30) Priorität: 08.02.1994 DE 4403907
(71) Anmelder: VOBIS MICROCOMPUTER AG, D-52146 Würselen (DE)
(72) Erfinder: Enders, Gerdum, 34119 Kassel (DE); Knierim, Andreas, 34119 Kassel (DE); Wacholder, Kai, 34131 Kassel (DE)
(74) Vertreter: Bauer, Wulf, Dr.

(57) **Zusammenfassung**

Bei dem Personalcomputer mit einem Gehäuse (20), einer Hauptplatine (22), die Steckplätze für Steckkarten (24) aufweist, sowie Steckkarten (24), die in diese Steckplätze einsteckbar sind und im Gehäuse in diesem Zustand mittels einer Haltevorrichtung gehalten sind, istdie Haltevorrichtung eine alle einsteckbaren Steckkarten übergreifende Klemmleiste (36) ist, die im eingesetzten Zustand alle Steckkarten (24) fixiert und die im Freigabezustand alle Steckkarten (24) freigibt, und die elastische Bereiche aufweist, die den einzelnen Steckkarten (24) zugeordnet sind.

## Beschreibung

Die Erfindung bezieht sich auf einen Personal-Computer mit einem Gehäuse, einer Hauptplatine, die Steckplätze für Steckkarten aufweist, sowie Steckkarten, die in diese Steckplätze einsteckbar sind und im Gehäuse im eingesteckten Zustand mittels einer Haltevorrichtung lösbar gehalten sind.

Das Gehäuse eines Personal-Computers nimmt als wesentlichen, unabdingbaren Bestandteil die sogenannte Hauptplatine, englisch auch häufig Mainboard oder Motherboard genannt, auf. Sie weist eine Anzahl von Steckplätzen für Steckkarten auf. Bei diesen Steckplätzen handelt es sich um Vielfachsteckverbinder. In diese Steckplätze können Steckkarten eingesteckt werden, sie sind zunächst mit der Hauptplatine mechanisch nur über die Vielfachsteckverbindung verbunden. Eine ausreichende mechanische Fixierung der Steckkarte wird durch die Haltevorrichtung erreicht. Durch sie werden die einzelnen Steckkarten mechanisch mit dem Gehäuse lösbar verbunden. Da auch die Hauptplatine mechanisch mit dem Gehäuse verbunden ist, wird insgesamt eine mechanische Verbindung zwischen Steckkarte und Hauptplatine erreicht, die auch gewisse mechanische Belastungen aushält.

Typische Steckkarten von Personal-Computern umfassen sogenannte Controller für Laufwerke, VGA-Karten, Eingangs-/ Ausgangskarten, zusätzliche Schnittstellenkarten usw.

Beim Zusammenbau eines Personal-Computers wird die Hauptplatine eingesetzt, meist auf Steckpfosten aufgesteckt. Sie befindet sich üblicherweise in geringem Abstand vom Bodenblech des Gehäuses. In die Steckplätze der Hauptplatine werden sodann die benötigten Steckkarten eingesteckt und später fixiert. Die Steckkarten bestehen im wesentlichen aus einer Leiterplatine, die zugleich einen Teil der Steckverbindung ausbildet, und aus einem L-förmigen Halteflansch, der in der Regel aus Metall gefertigt ist und Steckverbinder aufnimmt, mit denen externe Verbindungen hergestellt werden können. Das Gehäuse des Computers hat an seiner Rückwand Fenster, für jeden Steckplatz ist normalerweise ein derartiges Fenster vorgesehen. Die Halteflansche decken mit ihrem langen Schenkel dieses Fenster ab. Steckverbinder, die sich auf diesem Teil des Halteflansches befinden, sind durch das Fenster hindurch an der Rückseite des Computers zugänglich.

Beim Einsetzen kommt der kurze Flansch des Halteflansches in Anlage auf einem Podest, das vom Gehäuse ausgebildet wird. In bekannter Weise hat dieses Podest Gewindebohrungen und haben die kurzen Schenkel der Halteflansche Bohrungen. Beim Einstecken der Steckkarten in die Steckplätze paßt jeweils eine Bohrung auf eine Gewindebohrung. Mittels einer separaten Schraube kann nun die Steckkarte mit dem Gehäuse verschraubt werden, indem der kurze Flansch des Halteflansches gegen das genannte Podest gedrückt wird.

Diese Montage der Steckkarten hat Nachteile. In vielen Fällen werden selbstschneidende Schrauben verwendet, die bei mehrmaligem Ein- und Herausschrauben nicht mehr ausreichenden Halt bieten, weil das Gewinde relativ rasch verschleißt. Für das Gewinde steht nur die normale Blechstärke des Gehäuses des Computers zur Verfügung. Fehler können aber auch dadurch auftreten, daß Gewinde durch unsachgemäße Behandlung beschädigt werden. Darüberhinaus passiert es häufig, daß die Schrauben vor dem Einsetzen oder Greifen ins Gehäuseinnere fallen und sich insbesondere zwischen Mainboard und der Bodenplatte des Gehäuses verfangen oder anderweitig ungewollt zwischenrutschen, beispielsweise in das Netzteil oder ein Laufwerk. Durch derartige vagabundierende Schrauben könne erhebliche Probleme auftreten, es kann soweit kommen, daß der Computer durch die Schrauben nicht mehr ordnungsgemäß funktioniert.

Eine Steckkarte wird nicht nur beim Aufbau des Computers gehandhabt, sondern auch später bei Wartungsarbeiten, insbesondere bei einer Fehlersuche. Schließlich nimmt der Computerbenutzer häufig selbst einen Austausch von Steckkarten oder einen Einsatz neuer Steckkarten vor, beispielsweise wenn er seinen Computer aufrüsten will. Bei all diesen Handhabungen können die genannten Probleme mit den Schrauben und ihren zugeordneten Gewinden auftreten.

Hier setzt nun die Erfindung ein. Sie hat es sich zur Aufgabe gemacht, die mechanische Verbindung der Steckkarten mit dem Gehäuse so weiter zu entwickeln und auszubilden, daß die genannte Schraubbefestigung vermieden und durch eine Befestigungsteil ersetzt wird, das einerseits so groß ist, daß es bei unsachgemäßer Handhabung nicht irgendwo im Computer verlorengehen kann und andererseits so ausgebildet ist, daß klar erkannt werden kann, daß alle Steckkarten positiv mechanisch fixiert sind.

Gelöst wird diese Aufgabe ausgehend von den Computer mit den Merkmalen der eingangs Art dadurch, daß die Haltevorrichtung eine alle einsteckbaren Steckkarten übergreifende Klemmleiste ist, die im eingesetzten Zustand die Steckkarten elastisch fixiert und im Freigabezustand alle Steckkarten freigibt und die elastische Bereiche aufweist, die den einzelnen Steckkarten zugeordnet sind.

Erfindungsgemäß werden die einzelnen Schrauben ersetzt durch eine Klemmleiste, die für alle Steckkarten zuständig ist. Sie stellt sicher, daß die kurzen Flansche der Halteflansche jeder Steckkarte, einschließlich der Blindverblendungen, gegen das Podest des Gehäuses gedrückt werden. Ist die Haltevorrichtung freigegeben, was durch Herausnehmen oder Ausschwenken oder anderweitig erfolgen kann, können alles Steckkarten herausgenommen werden, ebenso die Blindverblendungen. Im eingesetzten Zustand hält die Klemmleiste alle Steckkarten und Blindverblendungen fixiert.

Erfindungsgemäß wird durch die eine Klemmleiste erreicht, daß es weder mit vagabundierenden Schrauben noch mit ausgefransten Gewinden zu einem Problem kommen kann. Die elastischen Bereiche der Klemmleiste sorgen dafür, daß jede einzelne Steckkarte ausreichend sicher und dauerhaft gegen das Podest gedrückt wird, ohne daß die Steckkarten mechanisch aus ihren Steckplätzen freikommen können.

In einer bevorzugten Weiterbildung hat das Gehäuse einen oberhalb des Podestes vorspringenden Rand. In diesem Fall ist die Klemmleiste ein Stab, der zwischen diesem Rand und dem Podest eingedrückt wird und durch geeignete Mittel, insbesondere einen Snap-in Verbindung, festliegt. In diesem Fall kann die Klemmleiste vollständig vom Gehäuse getrennt werden. Sie kann aber auch mit diesem über geeignete Mittel, beispielsweise ein Gelenk oder eine Schnur verbunden bleiben. Die Klemmleiste stützt sich einerseits am vorspringenden Rand des Gehäuses und andererseits an den kurzen Flanschen der Steckkarten, die auf dem Podest liegen, ab und drücken diese Teile so voneinander weg, daß eine ausreichende mechanische Befestigung erzielt wird.

In einer anderen, bevorzugten Ausbildung, die ohne einen zusätzlichen, vorspringenden Rand auskommen, ist die Klemmleiste am Gehäuse gelenkig gelagert, vorzugsweise ist diese Gelenkverbindung lösbar. Der Klemmleiste ist ein Haltevorsprung zugeordnet, den sie im Klemmzustand untergreift, wodurch gleichzeitig der Klemmzustand gesichert wird und sich die Klemmleiste zusätzlich zur Gelenkverbindung am Gehäuse abstützen kann. Die Achse der Gelenkverbindung, mit der die Klemmleiste am Gehäuse angelenkt ist, kann parallel zur Steckrichtung der Steckkarten oder im rechten Winkel hierzu verlaufen. Besonders bevorzugt ist die Klemmleiste an der Oberkante der Rückwand des Gehäuses angelenkt und kann nach unten auf die großen Flansche der Steckkarten geklappt werden. In diesem Klemmzustand wird sie durch Haltevorsprünge, die sie untergreift und in denen sie elastisch gehalten ist, fixiert.

Als besonders vorteilhaft hat es sich erwiesen, daß die Klemmleiste einzelne, elastisch vorbelastete Vorsprünge hat, die im wesentlichen noppenförmig ausgebildet sind und wie die Schrauben sowohl in die Öffnung des kurzen Flansches als auch in die darunterliegende Gewindebohrung des Podests eingreifen. Auf diese Weise wird eine Lokalisierung der Steckkarten erreicht, wie sie auch bei den bisherigen Schraubenbefestigungen erzielt wurde. Bei erfindungsgemäß ausgebildeten Computer-Gehäusen muß die Bohrung im Podest nicht mehr als Gewindebohrung ausgeführt sein. Es genügt eine einfache Bohrung.

Im Klemmzustand wird die Klemmleiste vorzugsweise durch eine einfach lösbare elastische Verbindung gehalten, insbesondere durch die bereits erwähnte Snap-in Verbindung. Die Klemmleiste rastet hörbar ein, wenn sie den Klemmzustand erreicht hat. Durch einfache Hilfsmittel wird die elastische Halterung der Klemmleiste im Klemmzustand so angehoben oder ausgelenkt, daß die Klemmleiste wieder frei geschwenkt werden kann. Im freigeschwenkten Zustand behindert die Klemmleiste den Weg der Steckkarten nach oben nicht.

Um zu vermeiden, daß die Blindverblendungen freikommen und eventuell sogar herunterfallen, wenn die Klemmvorrichtung freigegeben wird, hat es sich als besonders vorteilhaft erwiesen, die kurzen Flansche der Blindverblendungen mit einem druckknopfähnlichen Vorsprung zu versehen, der anstelle der sonst verwendeten Schraube nach unten vorsteht. Der Druckknopf, der insbesondere als Kunststoffteil ausgebildet sein kann, wird in die Bohrung des Podests eingedrückt und fixiert die Blindverblendung so ausreichend, daß die bei der Freigabebewegung der Klemmleiste nicht freikommt. Vielmehr muß die Blindverblendung noch mit geringer Kraft angehoben werden, damit sie von ihrem Platz freikommt. Derartige druckknopfartige Eingriffteile können auch nachträglich an den Steckkarten vorgesehen werden. Sie ersetzen dann die beschriebenen Noppen oder sind so ausgebildet, daß die Noppen in sie eingreifen können. Hier muß aber beachtet werden, daß die Steckkarten von einer großen Anzahl von Zulieferern hergestellt werden, sodap die druckknopfartige Befestigung nur nachträglich angebracht werden kann. Blindverblendungen werden dagegen zumeist vom Computerhersteller speziell bezogen und können von vornherein mit der gewünschten Druckknopfbefestigung ausgebildet sein.

Weitere Vorteile und Merkmale der Erfindung ergeben sich aus den übrigen Ansprüchen sowie aus der nun folgenden Beschreibung von nicht einschränkend zu verstehenden Ausführungsbeispielen, die unter Bezugnahme auf die Zeichnungen näher erläutert werden. In dieser zeigen:
- FIG. 1:: eine perspektivische Darstellung (als Montagebild) eines Computers mit geöffnetem Gehäuse, Hauptplatine und drei Steckkarten sowie eine Klemmvorrichtung,
- FIG. 2:: eine Seitenansicht einer zweiten Ausführung einer Klemmvorrichtung,
- FIG. 3:: eine Rückansicht der Klemmvorrichtung gemäß FIG. 2,
- FIG. 4:: eine Draufsicht auf die Klemmvorrichtung gemäß FIG. 2,
- FIG. 5:: eine Seitenansicht einer Gehäuserückwand in prinzipieller Darstellung mit angelenkter Klemmleiste zur Erläuterung eines dritten Ausführungsbeispiels zur Erfindung und
- FIG. 6:: eine Draufsicht auf die Rückwand eines Gehäuses mit angelenkter Klemmleiste zur Erläuterung eines vierten Ausführungsbeispiels der Erfindung.

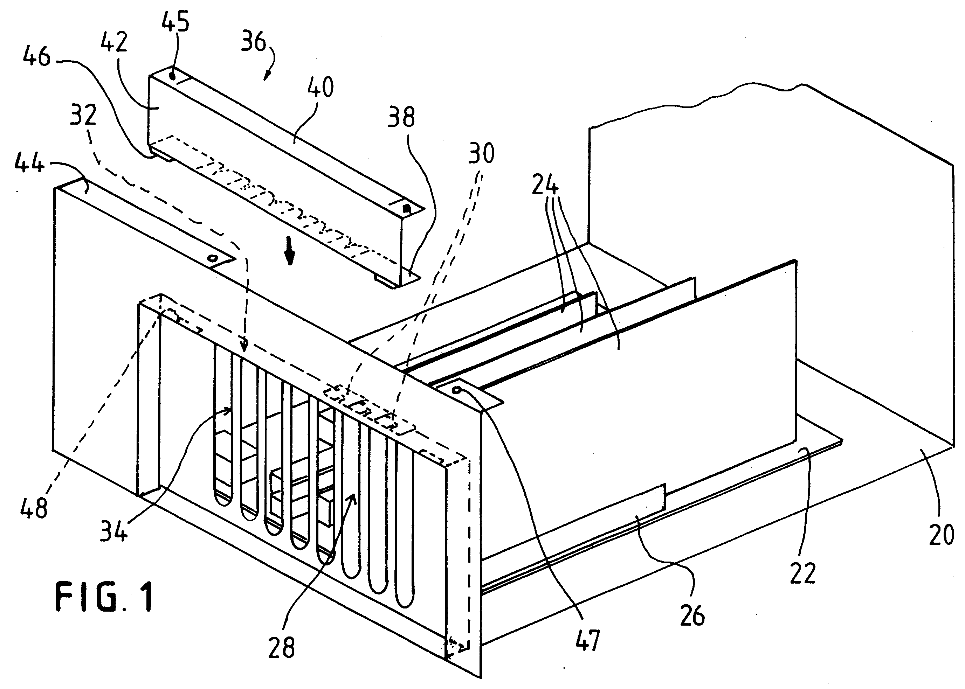

Von einem Gehäuse 20 eines Personalcomputers ist in FIG. 1 nur der untere Teil gezeigt, er ist im wesentlichen U-förmig und bildet Frontplatte, Bodenplatte und Rückwand aus. Ein ähnlich geformtes, zweites Teil wird von oben aufgestülpt und bildet die linke und rechte Seitenwand sowie die obere Wand aus, es ist nicht dargestellt. In bekannter Weise ist auf der Bodenplatte eine Hauptplatine 22 befestigt. Sie bildet mehrere Steckplätze für Steckkarten 24 aus, insgesamt sind in FIG. 1 drei eingesteckte Steckkarten 24 dargestellt. In bekannter Weise sind auf der Hauptplatine (22) mehrere, z. B. acht Vielfachsteckverbinder 26 vorgesehen, in die die Leiterplatinen der Steckkarten 24 unmittelbar eingesteckt werden können. Die Steckkarten 24 haben darüberhinaus Halteflansche 28, die einen langen, entlang einer Schmalseite der Leiterplatine sich erstreckenden Flansch und einen kurzen Flansch 30 ausbilden. Letzterer liegt in der Darstellung gemäß FIG. 1 auf einem Podest 32 aus, daß das Gehäuse 20 ausbildet.

Unterhalb des Podestes 32 sind im Gehäuse Fenster 34 vorgesehen, ihre Anzahl entspricht der Anzahl der Steckplätze. Sie werden durch die langen Flansche des Halteflansches 28 abgedeckt. Nicht besetzte Steckplätze werden durch sogenannte Blindverblendungen abgedeckt, sie sind ebenso aufgebaut wie die Halteflansche 28.

Um eine sichere Befestigung der Steckkarten 24 dauerhaft erreichen zu können, können diese nicht nur im Vielfachsteckverbinder 26 elektrisch und mechanisch gehalten sein, sondern werden zusätzlich an ihren kurzen Flanschen 30 am Podest 32 befestigt. Beim Stand der Technik geschieht dies mittels Schrauben, die in Bohrungen eingreifen, welche im kurzen Flansch 30 ausgebildet sind. Im Podest 32 befinden sich Gewindebohrungen.

Erfindungsgemäß werden die kurzen Flansche 30 nicht einzeln am Podest 32 befestigt, sondern mittels einer für alle Steckplätze und damit für alle Steckkarten 24 gemeinsamen Klemmleiste 36, auf die im folgenden näher eingegangen wird.

Die Klemmleiste 36 nach dem bislang besprochenen Ausführungsbeispiel, aber auch diejenigen nach den weiteren Ausführungsbeispielen, verfolgen stets das Prinzip, daß die kurzen Flansche 30 elastisch gegen das Podest 32 gedrückt werden. Die Klemmleiste 36 stützt sich dabei am Gehäuse 20 in unterschiedlicher Weise ab, sie stützt sich stets am Gehäuse 20 ab und leitet die notwendigen Klemmkräfte in die kurzen Flansche 30 ein.

Im Ausführungsbeispiel nach FIG. 1 ist die Klemmleiste 36 im wesentlichen ein U-förmiges Teil, das auch als rinnenförmig beschrieben werden kann. Es hat einen unteren Flansch 38, der elastisch ausgebildet ist und zur Auflage auf den kurzen Flanschen 30 bestimmt ist. Es hat weiterhin einen oberen Flansch 40, mit dem sich die Klemmleiste 36 am Gehäuse 20 abstützt. Schließlich hat es einen Basisflansch 42, der diesen beiden Flansche 38, 40 miteinander verbindet. Er ist maximal 20 mm hoch, anders ausgedrückt haben die beiden Flansche 38, 40 voneinander einen Abstand, der maximal 20 mm beträgt. Im oberen Flansch 40 sind randseitig Federbereiche ausgebildet, von denen Noppen hochstehen. Am Gehäuse 20 springt an der Oberkante der Rückwand ein Vorsprung 44 vor, er erstreckt sich allerdings außerhalb des Feldes oberhalb der kurzen Flansche 30, sodaß er den Weg beim Einstecken und beim Herausziehen der Steckkarten 24 nicht behindert. Im Vorsprung sind Löcher vorgesehen, in die die beschriebenen Noppen der Federbereiche des oberen Flansches 40 elastisch einrasten können. In Verlängerung des Basisflansches 42 springen vom unteren Flansch 38 Verlängerungen 46 vor, die in Schlitze 48 eingreifen können, welche im Podest 32 vorgesehen sind.

Beim Einsetzen der Klemmleiste 36 gemäß FIG. 1 werden zunächst die Verlängerungen 46 in die Schlitze 48 eingesteckt, dabei kann das Teil noch schräg gehalten werden. Die Verlängerungen 46 sind entsprechend lang, daß sie auch im schräg gestellten Zustand der Klemmleiste 36 bereits in die Schlitze 48 eingreifen. Beim Festklemmen wird nun die Klemmleiste 36 so zur Rückwand des Gehäuses 26 hin gedrückt, daß die Federbereiche die Vorsprünge 44 untergreifen und ihre Noppen in die erwähnten Bohrungen einschnappen können. In diesem Zustand ist die Fixierung aller Steckkarten 24 einschließlich der Blindverblendungen erreicht.

Zum Lösen genügt es, die Federbereiche, die eingeschnappt sind, herunterzudrücken, bis der obere Flansch 40 wieder von der Rückwand weg zum Inneren des Gehäuses gezogen werden kann. Sobald der obere Flansch 40 frei von den Vorsprüngen 44 ist, kann die Klemmleiste 36 weggezogen werden, sie ist dann frei von den anderen Bauteilen.

Im unteren Flansch 38 sind einzelne Federbereiche vorgesehen, die jeweils einem kurzen Flansch 30 zugeordnet sind. Auf diese Weise werden die einzelnen kurzen Flansche 30 gegen das Podest 32 separat gedrückt.

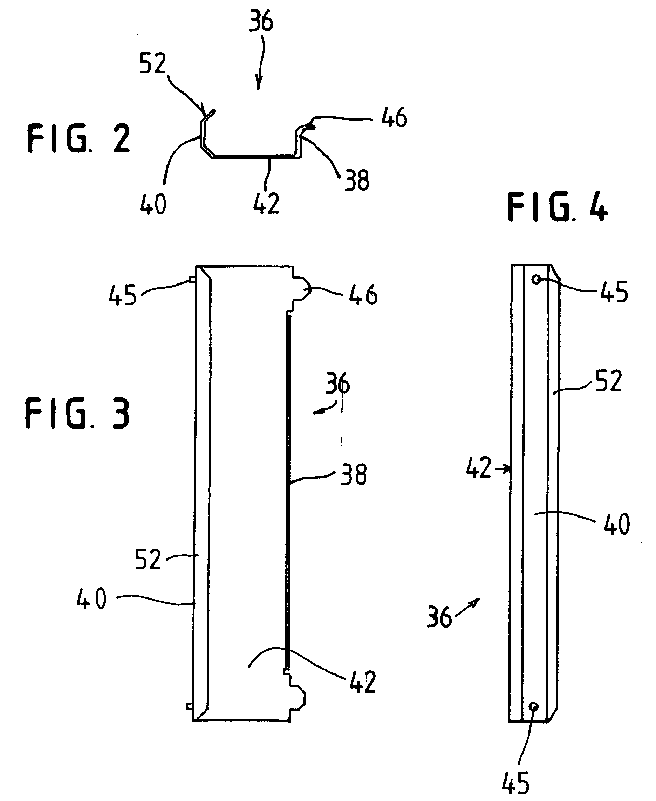

In den Figuren 2 bis 4 ist ein weiteres Ausführungsbeispiel gezeigt, dasähnlich der bereits beschriebenen Ausführung ist. Auch hier ist die Klemmleiste 36 ein im wesentlichen einstückiges Bauteil, das im gelösten Zustand als separates Teil vorliegt. Zu erkennen sind zwei Verlängerungen 46, denen wiederum entsprechende Schlitze im Gehäuse zugeordnet sind. Sie springen vom unteren Flansch 38 in Verlängerung des Basisflansches 42 nach unten vor. Sie sind vom mittleren Hauptteil des unteren Flansches 38 durch Schlitze getrennt, sodaß der mittlere Hauptteil sich unabhängig von ihnen bewegen kann. Der obere Flansch 40 ist aus drei Bereichen zusammengesetzt. Es wird eine Anlaufschräge erzielt, die das Herunterdrücken des oberen Flansches 40 unter die Vorsprünge 44 vereinfacht. Zu erkennen sind die Noppen 45, die an den Endbereichen des oberen Flansches 40 vorspringen und wiederum in Bohrungen 47 eingreifen, die in den Vorsprüngen 44 vorgesehen sind.

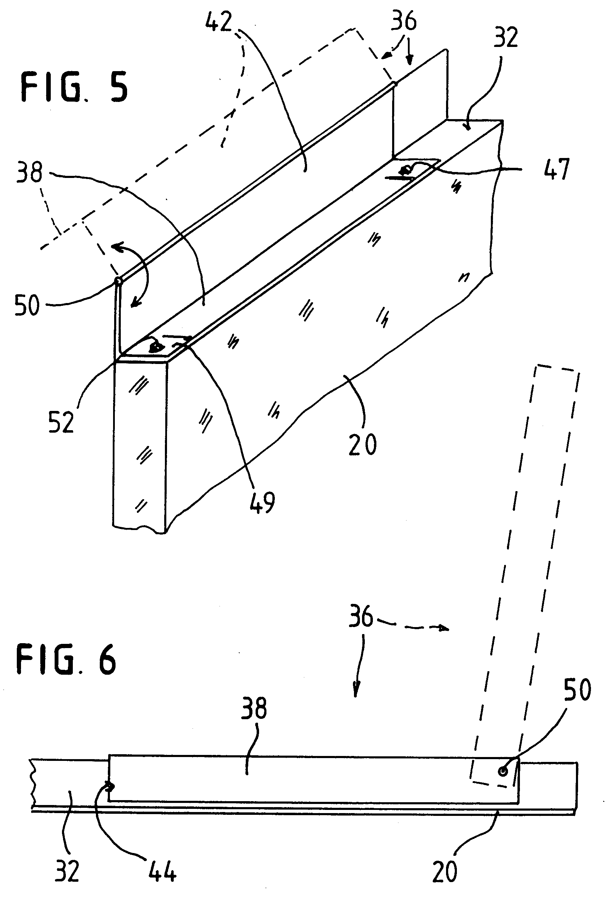

Im Ausführungsbeispiel nach FIG. 5 ist die Klemmleiste im wesentlichen im Profil L-förmig. Sie ist mit ihrem Basisflansch 42 oben an der Oberkante der Rückwand des Gehäuses 20 mittels eines Gelenks 50 angelenkt. Die Gelenkachse erstreckt sich damit parallel zur Oberkante der Rückwand des Gehäuses 20. Dargestellt ist der Klemmzustand in ausgezogenen Strichen, in gestrichelter Ausführung ist der Freigabezustand ersichtlich. Die Klemmleiste nach FIG. 5 hat (lediglich) einen unteren Flansch 38, der wiederum die Aufgabe hat, mit einzeln unterteilten, elastischen Bereichen die einzelnen kurzen Flansche 30 gegen das Podest 32 zu drücken. Er ist somit ähnlich ausgebildet wie in den vorangehend beschriebenen Beispielen. Um den gezeigten Klemmzustand zu sichern, hat der untere Flansch 38 an seinen Extrembereichen separate Federbereiche 49, die beispielsweise durch einen Schnitt vom mittleren Bereich getrennt sind, es liegen hier ähnliche Voraussetzungen wie beim unteren Flansch 38 nach dem Ausführungsbeispiel 4 vor wie beim Ausführungsbeispiel gemäß den Figuren 2 bis 4. Am Podest 32 des Gehäuses 20 springen außerhalb des Bereiches, der für die kurzen Flansche 30 bestimmt ist, dreieckförmige Auflaufschrägen 52 vor. In den beschriebenen Extrembereichen sind diesen Auflaufschrägen 52 zugeordnete Fenster 47 vorgesehen. Im Klemmzustand greift eine Auflaufschräge 52 mit ihrer steilen Kante gegen einen Rand des Fensters und sichert somit den Klemmzustand. Durch einfaches Anheben der Extrembereiche des unteren Flansches 38, beispielsweise mittels eines Schraubenziehers, kommen diese von den Auflaufschrägen 52 frei und kann die Klemmleiste 36 in die Freigabestellung geschwenkt werden.

Das Ausführungsbeispiel nach FIG. 5 hat den Vorteil, daß die Klemmleiste 36 unverlierbar mit dem Gehäuse 20 verbunden ist.

FIG. 6 schließlich zeigt ein weiteres Ausführungsbeispiel, bei dem die Klemmleiste 36 mittels eines Gelenks 50 mit dem Gehäuse 20, und mit der Rückwand des Gehäuses 20, verbunden ist. In diesem Fall verläuft jedoch die Schwenkachse des Gelenks 50 parallel zur Steckrichtung der Steckkarten 24. Die Klemmleiste 36 besteht im wesentlichen lediglich aus einem unteren Flansch 38, der sich über die Länge des Podests 32 erstreckt, wo sich die Auflagefläche für die kurzen Flansche 30 befindet. Jenseits dieser Auflageläche am Podest 32, und zwar dem Gelenk 50 gegenüberliegend, ist ein Vorsprung 44 vorgesehen, unter den die Klemmleiste 36 greift, wenn sie sich in der Klemmstellung befindet. Wiederum ist eine Auflaufschräge 52 am Podest angeordnet, die mit einem Fenster in der Klemmleiste 36 zusammenwirkt und die Klemmstellung sicherstellt.

Dieses Ausführungsbeispiel nach FIG. 6 hat den Vorteil, daß die Bauhöhe ausgesprochen gering sein kann, die Gehäusehöhe wird also durch die erfindungsgemäße Klemmleiste 36 praktisch nicht vergrößert.

Auch im Ausführungsbeispiel nach FIG. 6 hat die Klemmleiste in ihrem beim Einschwenken in die Klemmposition vor liegenden Bereich eine Anschrägung, die nach oben gerichtet ist und verhindert, daß die in dieser Bewegungsrichtung vordere Kante der Klemmleiste 36 irgendwo mechanisch anschlägt. Vielmehr wird durch die Schräge erreicht, daß die Klemmleiste 36 sich über die kurzen Flansche 30 schiebt und diese elastisch fixiert, sobald der dem Gelenk 50 gegenüberliegende Endbereich der Klemmleiste 36 unter den Vorsprung 44 gelangt und mittels der Auflaufschräge 52 arretiert ist.

Weitere Ausführungen der Klemmleiste 36 sind möglich, die beschriebenen Ausführungsbeispiele sind lediglich mögliche Formen einer Realisierung.

Es ist bevorzugt, die Klemmleiste 36 aus Federstahl herzustellen, zumindest überwiegend aus Federstahl.

## Patentansprüche

1. Personalcomputer mit einem Gehäuse (20), einer Hauptplatine (22), die Steckplätze für Steckkarten (24) aufweist, sowie Steckkarten (24), die in diese Steckplätze einsteckbar sind und im Gehäuse in diesem Zustand mittels einer Haltevorrichtung gehalten sind, dadurch gekennzeichnet, daß die Haltevorrichtung eine alle einsteckbaren Steckkarten übergreifende Klemmleiste (36) ist, die im eingesetzten Zustand alle Steckkarten (24) fixiert und die im Freigabezustand alle Steckkarten (24) freigibt, und die elastische Bereiche aufweist, die den einzelnen Steckkarten (24) zugeordnet sind.

2. Personalcomputer nach Anspruch 1, dadurch gekennzeichnet, daß das Gehäuse einen Vorsprung (44) aufweist, die ein Widerlager für die Klemmleiste (36) im Klemmzustand bildet.

3. Personalcomputer nach Anspruch 1, dadurch gekennzeichnet, daß die Klemmleiste (36) Verlängerungen (46) aufweist, die von einem unteren Flansch (38), der die Fixierung der Steckkarten (24) bewirkt, vorspringen, daß im Gehäuse (20) diesen Verlängerungen (46) zugeordnete Schlitze (48) vorgesehen sind und daß beim Einsetzen der Klemmleiste (36) die in die Schlitze (48) eingeführten Verlängerungen (46) eine Art Gelenk bilden.

4. Personalcomputer nach Anspruch 1, dadurch gekennzeichnet, daß die Klemmleiste (36) mittels eines Gelenks (50) am Gehäuse (20) schwenkbar befestigt ist.

5. Personalcomputer nach Anspruch 4, dadurch gekennzeichnet, daß die Achse des Gelenks (50) parallel zur Steckrichtung der Steckkarten (24) oder parallel zur Oberkante der Hinterwand des Gehäuses (20) verläuft.

6. Personalcomputer nach Anspruch 1, dadurch gekennzeichnet, daß die Klemmleiste (36) an einem äußeren Randbereich eines Flansches, z. B. des unteren Flansches (38), Randbereiche aufweist, die vom Mittelbereich getrennt sind, elastisch federnd ausgebildet sind und einen Vorsprung, z. B. eine Noppen oder ein Fenster tragen und daß am Gehäuse (20) diesen Bereichen entsprechende Vorsprünge, z. B. eine Auflaufschräge (52) oder eine Bohrung vorgesehen sind, sodaß ein Zusammenwirken dieser Teile in die Klemmleiste (36) im Klemmzustand sichert und durch Anheben der federnden Randbereiche die Klemmposition wieder verlassen werden kann.

7. Personalcomputer nach Anspruch 1, dadurch gekennzeichnet, daß ein Flansch (38) der Klemmleiste (36), der unmittelbar in Kontakt mit den Steckkarten (24) kommt, eine Anschrägung aufweist, die bewirkt, daß bei einer Bewegung der Klemmleiste (36) in die Klemmstellung die zu klemmenden Bereiche der Steckkarten (24) diese Bewegung nicht hindern oder blockieren.

8. Personalcomputer nach Anspruch 1, dadurch gekennzeichnet, daß der unmittelbar die Klemmung bewirkende Flansch (38) der Klemmleiste (36) einzelne, elastisch ausgebildete Bereiche aufweist, die den jeweiligen Steckkarten (24) zugeordnet sind.
